# FASCICULE DE BREVET EUROPEEN

(11) **EP 0 891 597 B1**
(45) Date de publication et mention de la délivrance du brevet: **16.02.2000**
(21) Numéro de dépôt: 97919459.4
(22) Date de dépôt: 02.04.1997
(51) Int. Cl.: G06K 7/08, G06K 19/07

(54) **OBJET ELECTRONIQUE PORTATIF POUR L'ECHANGE D'INFORMATIONS A DISTANCE**
TRAGBARES ELEKTRONISCHES OBJEKT FÜR DATENFERNÜBERTRAGUNG
PORTABLE ELECTRONIC OBJECT FOR REMOTE INFORMATION EXCHANGE

(30) Priorité: 03.04.1996 FR 9604179
(43) Date de publication de la demande: 20.01.1999
(73) Titulaire: FRANCE TELECOM, 75015 Paris (FR)
(72) Inventeur: BOUVIER, Jacky, F-38240 Meylan (FR)
(74) Mandataire: Casalonga, Axel
(86) Numéro de dépôt international: FR9700584
(87) Numéro de publication internationale: WO9738391

(56) Documents cités:
- EP-A- 0 542 229
- IEEE JOURNAL OF SOLID-STATE CIRCUITS, vol. 30, no. 3, 1 Mars 1995, pages 306-310, XP000502816 KAISER U ET AL: "A LOW-POWER TRANSPONDER IC FOR HIGH-PERFORMANCE IDENTIFICATION SYSTEMS"

## Description

L'invention concerne l'échange d'informations à distance entre un objet électrique portatif, en particulier une carte électronique à mémoire ou carte à puce, et un terminal par une modulation du champ magnétique généré par le terminal.

Dans ce genre d'échange de données à distance, le champ magnétique généré par le terminal sert à alimenter les composants électroniques de l'objet portatif, et à transmettre simultanément des données numériques par une modulation.

Différentes sortes de modulation peuvent être envisagées.

Actuellement, on utilise généralement une modulation de fréquence ou de phase pour la transmission des informations entre le terminal et l'objet. Dans le sens d'une transmission de l'objet portatif vers le terminal, on utilise généralement une modulation par absorption.

Pour une transmission depuis le terminal vers l'objet portatif, on peut également envisager un autre type de modulation, à savoir une modulation par amplitude ce qui offre l'avantage d'éviter d'utiliser des boucles à verrouillage de phase et conduit donc à un système simple.

Un objet portatif communiquant par modulation d'amplitude d'un champ magnétique est décrit dans EP-A-0 542 229.

Cependant, étant donné que l'objet portatif, alimenté par le champ magnétique, est soumis à des déplacements dans le champ magnétique, notamment lorsque l'utilisateur approche sa carte du terminal puis l'en éloigne, la tension récupérée au nivau de la carte augmente lorsque la carte est très proche de l'antenne rayonnante du terminal, et peut atteindre facilement la tension de claquage des jonctions des transistors ce qui conduit alors à une altération du fonctionnement des composants électroniques de cette carte. Il est donc nécessaire de limiter cette tension récupérée à une valeur limite. Or, un simple écrêtement de la tension ferait disparaître la modulation d'amplitude de cette dernière, modulation qui supporte les échanges d'informations.

L'invention a donc pour but d'apporter une solution à ce problème, et notamment, de limiter la variation de tension récupérée tout en conservant les informations numériques contenues dans cette tension récupérée, et ceci dans les deux sens de transmission.

L'invention propose donc un procédé d'échange d'informations à distance entre un objet électronique portatif, en particulier une carte à mémoire, et un terminal par une modulation du champ magnétique généré par le terminal, selon lequel lors d'une transmission d'informations depuis le terminal vers l'objet, on effectue une modulation d'amplitude du champ magnétique, lorsque la tension d'alimentation ainsi modulée et récupérée au niveau d'une borne d'entrée de l'objet portatif, dépasse lors d'un pic de modulation une valeur limite choisie, on écrête cette tension à ladite valeur limite choisie tout en faisant circuler un premier courant dans un transistor principal connecté entre ladite borne d'entrée et la masse, puis, lors d'un creux de modulation, on fait circuler dans ce transistor principal un second courant d'une valeur sensiblement égale à celle du premier courant circulant lors du pic de modulation.

Ainsi, selon l'invention, puisque l'on maintient dans le transistor un courant sensiblement constant entre un pic et un creux de modulation, et puisque l'énergie ou la puissance du champ magnétique délivrée par le terminal varie entre un pic et un creux de modulation, on observera une diminution de la tension d'alimentation de l'objet portatif lors d'un creux de modulation. En d'autres termes, bien que la tension d'alimentation soit écrêtée lors d'un pic de modulation, la diminution de sa valeur lors d'un creux de modulation permettra de détecter aisément la variation d'amplitude de la tension et donc de ne pas perdre l'information transmise.

On maintient avantageusement le premier courant dans le transistor sensiblement constant entre un pic et un creux de modulation en maintenant sensiblement constante la tension de grille du transistor.

Pour une transmission d'informations depuis l'objet vers le terminal, qui s'effectue par une modulation par absorption, on commande, en fonction de la valeur logique des bits d'informations à transmettre, la conduction ou le blocage d'un transistor auxiliaire monté en miroir de courant avec le transistor principal.

En d'autres termes, selon la valeur logique des bits transmis, on rajoute au courant d'absorption circulant dans le transistor principal, un courant d'absorption supplémentaire circulant dans le transistor auxiliaire.

L'invention concerne également un objet électronique portatif, en particulier une carte à mémoire, capable d'échanger à distance des informations avec un terminal par une modulation du champ magnétique généré par le terminal; cet objet comprend un limiteur de tension comportant une borne d'entrée pour recevoir, lors d'une transmission d'informations entre le terminal et l'objet, une tension modulée en amplitude dont le niveau moyen est susceptible de varier temporellement, un transistor principal connecté entre la borne d'entrée et la masse, ainsi qu'un ensemble de diodes connectées en série d'une part entre la borne d'entrée et la masse et d'autre part entre la borne d'entrée et la grille du transistor principal, les tensions de seuil des diodes et du transistor principal définissant une valeur limite de la tension d'entrée, une capacité connectée entre la grille du transistor principal et la masse, et un réseau résistif connecté entre la capacité et la masse et formant avec cette capacité un réseau résistif/capacitif dont la constante de temps est choisie comprise entre la durée de variation temporelle du niveau moyen de la tension et la période de la modulation d'amplitude.

Selon un mode de réalisation de l'invention, l'ensemble de diodes comprend une première diode terminale dont la cathode est directement connectée à la grille du transistor principal et une deuxième diode terminale dont l'anode est reliée à l'anode de la première diode terminale et dont la cathode est reliée à la masse par l'intermédiaire d'une résistance de polarisation. Le réseau résistif comprend, outre la résistance de polarisation, un deuxième transistor à effet de champ connecté en série entre cette résistance de polarisation et la grille du transistor principal, la grille de ce deuxième transistor à effet de champ étant reliée à la masse. Cette première diode terminale, quoique non indispensable, permet, par son intermédiaire, la charge de la capacité, et permet donc de réduire le temps de charge.

Afin de ne pas perdre d'informations lors d'une transmission depuis l'objet portatif vers le terminal, le limiteur de tension comprend avantageusement une entrée de commande apte à recevoir un signal de commande dont la valeur dépend de la valeur des bits des informations transmises de l'objet vers le terminal, et un transistor auxiliaire monté en miroir de courant avec le transistor principal par l'intermédiaire d'un commutateur commandé par le signal de commande.

Selon un mode de réalisation de l'invention, le transistor auxiliaire est connecté entre la bande d'entrée et la masse et le commutateur comporte deux transistors complémentaires dont les grilles sont reliées à l'entrée de commande, l'un de ces deux transistors étant connecté entre la grille du transistor principal et la grille du transistor auxiliaire tandis que l'autre transistor est connecté entre la grille du transistor auxiliaire et la masse.

D'autres avantages et caractéristiques de l'invention apparaîtront à l'examen d'un mode de réalisation, nullement limitatif, et des dessins annexés sur lesquels :
- la figure 1 est un synoptique schématique d'un limitateur de tension selon l'invention,
- la figure 2 illustre très schématiquement la variation temporelle du niveau moyen de la tension d'alimentation lors d'un déplacement de la carte dans le champ magnétique, sans limiteur de tension, et
- la figure 3 illustre schématiquement les variations de la tension d'alimentation et du courant dérivé dans le transistor principal, lors des pics et des creux de modulation, sans (traits pleins) et avec (tiretés) limiteur de tension.

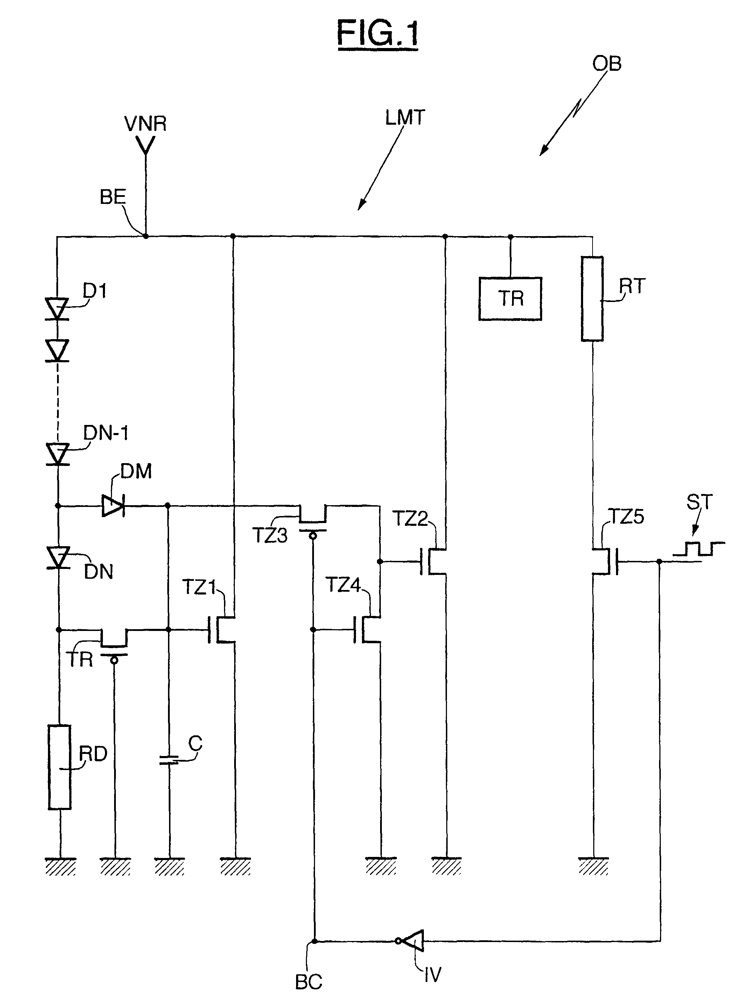

Tel qu'illustré sur la figure 1, l'objet portatif OB, par exemple une carte à "puce", comporte un limiteur de tension LMT possédant une borne d'entrée BE pour recevoir une tension d'alimentation redressée VNR issue d'un bloc primaire de structure classique, non représenté ici à des fins de simplification, connecté à une antenne de réception, également non représentée. Ce bloc primaire de structure classique assure les fonctions de redressement, de filtrage et également de stabilisation pour délivrer une tension d'alimentation stabilisée.

Le limiteur LMT comporte par ailleurs un ensemble de diodes D1-DN connectées en série. Plus précisément, l'anode de la première diode D1 est connectée à la borne d'entrée BE tandis que la cathode de la diode terminale DN est reliée à la masse par l'intermédiaire d'une résistance de polarisation RD. Un transistor TZ1 à effet de champ à canal N, dit transistor principal, est connecté, au niveau de son drain et de sa source, entre la borne d'entrée BE et la masse. La grille de ce transistor TZ1 est connectée à la cathode d'une autre diode terminale DM dont l'anode est reliée à l'anode de la diode terminale DN. La fonction de cette diode DM sera explicitée plus en détail ci-après.

La grille du transistor TZ1 est également reliée à la masse par l'intermédiaire d'une capacité C. Cette grille est enfin connectée à la cathode de la diode DN par l'intermédiaire d'un deuxième transistor à effet de champ TR, à canal P, dont la grille est reliée à la masse.

Un bloc de traitement des données référencé TR, comportant un bloc logique et un bloc mémoire, de structure classique, R est connecté à la borne d'entrée BE et est destiné à extraire les informations transmises depuis le terminal.

Pour assurer la transmission depuis l'objet vers le terminal, le limiteur de tension comprend en outre un transistor auxiliaire TZ2 monté en miroir de courant avec le transistor TZ1 par l'intermédiaire d'un commutateur formé ici de deux transistors complémentaires à effet de champ TZ3 et TZ4.

Plus précisément, le transistor TZ2 est connecté au niveau de son drain et de sa source entre la borne d'entrée BE et la masse tandis que sa grille est reliée d'une part à la masse par l'intermédiaire du transistor TZ4 à canal N, et, d'autre part à la grille du transistor TZ1 par l'intermédiaire du transistor TZ3 à canal P. Les grilles des deux transistors TZ3 et TZ4 sont reliées ensemble et ce point commun constitue une entrée de commande BC pour le commutateur TZ3, TZ4. Plus précisément, cette borne de commande BC reçoit, par l'intermédiaire d'un inverseur IV le signal logique ST, contenant les informations à transmettre, et délivré par un bloc de traitement non représenté ici à des fins de simplification. Bien entendu, l'objet portatif comprend également de façon classique, pour la transmission des informations depuis la carte vers le terminal, un transistor TZ5 connecté entre la masse et la borne d'entrée BE par l'intermédiaire d'une résistance RT, et commandé sur sa grille par le signal ST.

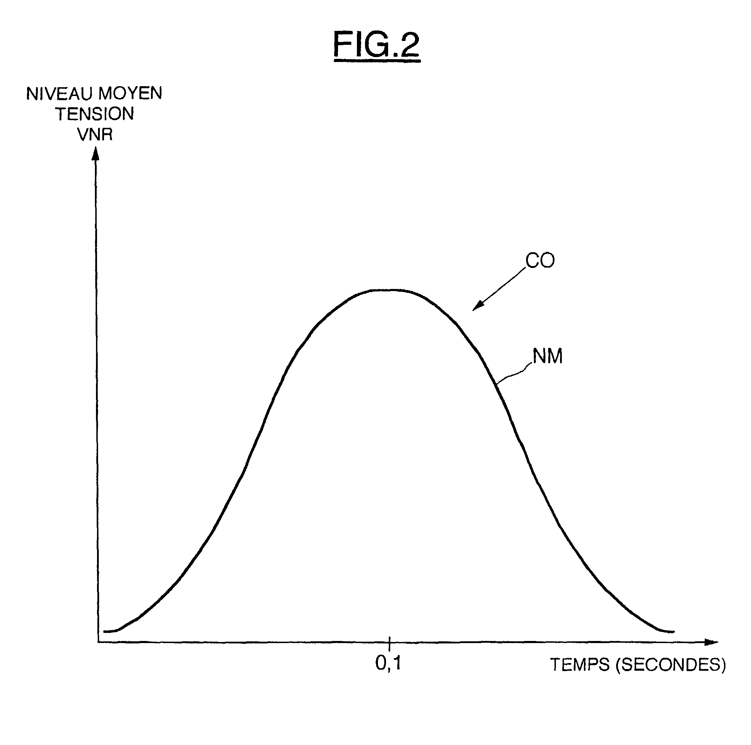

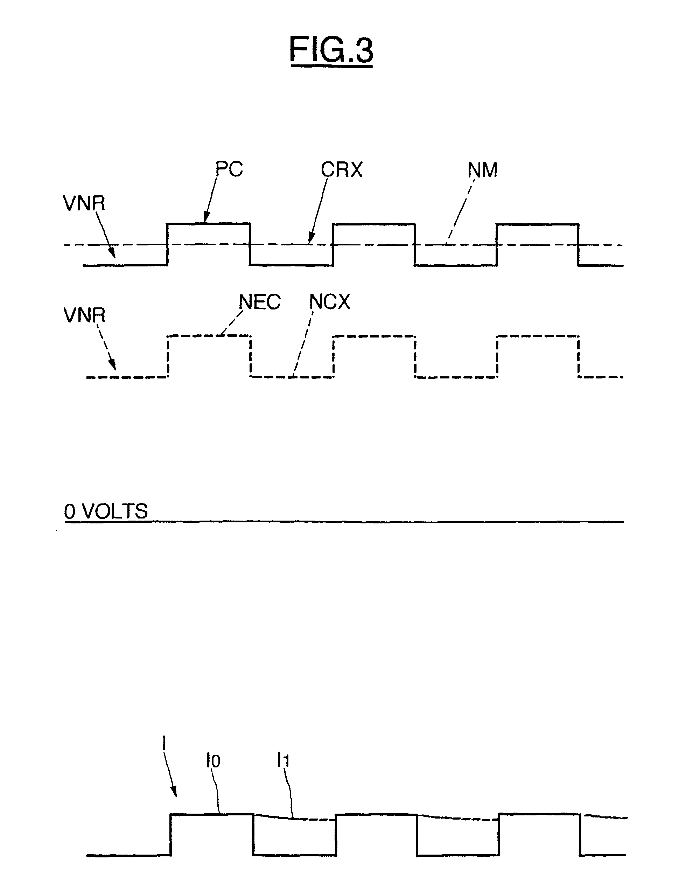

On va maintenant décrire plus en détail le fonctionnement du dispositif selon l'invention en se référant également aux figures 2 et 3.

L'ensemble de diodes D1...DN-1 et DM ainsi que le transistor principal TZ1 forment en fait, en technologie CMOS, une diode Zener dont la tension de Zener est égale à la somme de la tension de seuil du transistor TZ1 et des tensions de seuil des différentes diodes. Il est ainsi possible d'ajuster la tension de Zener en installant un nombre plus ou moins grand de diodes. Cette tension de Zener constitue donc la valeur limite d'écrêtement de la tension VNR. En pratique, en installant onze diodes de tension de seuil de l'ordre de 0,6 à 0,7 V, et en utilisant un transistor TZ1 dont la tension de seuil est de l'ordre de 0,5 V, on écrêtera la tension VNR à environ 8 V ce qui se situe en dessous de la tension de claquage des différentes jonctions des composants électroniques, qui est de l'ordre de 10 à 11 V.

Dans une application de type "portillon automatique" notamment, lorsque le possesseur de la carte s'approche du terminal, tend sa carte vers celui-ci, puis s'en éloigne en franchissant le portillon, le niveau moyen NM de la tension d'alimentation VNR suit en général la courbe CO de la figure 2 lorsque la carte n'est pas équipée d'un limiteur de tension selon l'invention. Lorsque la carte est équipée d'un limiteur de tension, ce niveau moyen est écrêté. La période de variation de cette tension est habituellement de l'ordre de quelques dixièmes de seconde. C'est notamment lorsque la carte est très proche du terminal, c'est-à-dire au niveau de la bosse de la courbe CO, que la tension d'alimentation risque d'atteindre la tension de claquage et qu'il convient de limiter sa valeur.

Pour la transmission des informations depuis le terminal vers la carte, la tension VNR est, comme illustré en traits pleins sur le haut de la figure 3, modulée en amplitude autour de son niveau moyen NM. Cette tension VNR modulée comporte ainsi des pics PC et des creux CRX de modulation, dont la période est de l'ordre de 104 microsecondes.

Lorsque, en particulier lors d'un pic de modulation PC, la tension d'alimentation VNR dépasse la valeur limite choisie, en l'espèce de l'ordre de 8 V, la tension VNR est en fait écrêtée par la diode Zener à la valeur de la tension de Zener et le transistor TZ1, dont la tension de seuil est atteinte, se met alors à conduire, le courant de conduction drain/source I ayant alors la valeur 10 (bas de la figure 3).

Par ailleurs, la capacité C se charge à la tension de seuil du transistor par l'intermédiaire de la diode DM. La constante de temps de charge de la capacité est définie par le produit n.Rz.C (où n est le nombre de diodes (ici 11) et Rz est la résistance de conduction d'une diode) et est inférieure à la période de variation du niveau moyen de la tension. En pratique, la constante de temps de charge est de l'ordre de 10 microsecondes (n.Rz = 600 kΩ et C = 20 pF).

La présence de la diode DM évite la charge de la capacité C par l'intermédiaire du transistor TR qui a une grande impédance et permet ainsi de limiter la constante de temps de charge.

Durant tout le temps du pic de modulation, la tension VNR est écrêtée au niveau NEC (haut de la figure 3, tiretés).

Lors du creux de modulation suivant, c'est-à-dire lorsque la tension VNR redescend en niveau, la diode DM passe en inverse et la capacité C se décharge dans le réseau résistif constitué par la résistance RD et le transistor TR. La constante de temps de décharge, qui est égale ici au produit de la capacité C par la somme de la résistance RD (ici 140 kΩ) et de la résistance de drain (ici 20 MΩ) du transistor TR, est choisie grande devant la période de la modulation d'amplitude et faible par rapport à la période de variation temporelle du niveau moyen de la tension. En pratique, cette constante de temps de décharge est prise égale à 500 µs.

Compte tenu de la valeur de cette constante de temps de décharge, la tension de grille du transistor TZ1 est maintenue sensiblement constante pendant le creux CRX de modulation et, par conséquent, la valeur I1 du courant de conduction du transistor TZ1 est sensiblement identique au courant I0 qui circulait pendant le pic de modulation.

En conséquence, puisque l'énergie transmise par le terminal pendant un creux de modulation baisse, et que le courant de conduction du transistor TZ1 reste sensiblement constant, la valeur de la tension VNR chute pour descendre au niveau NCX (haut de la figure 3, tiretés). De ce fait, la variation de tension entre le niveau écrêté NEC et le niveau NCX reste suffisante pour pouvoir déceler correctement un front de modulation.

L'homme du métier remarque ici qu'un simple écrêtement de la tension lors des pics de modulation sans maintien du courant de conduction dans le transistor lors d'un creux de modulation, aurait conduit à une tension écrêtée de niveau sensiblement constant entre un creux et un pic de modulation, ce qui n'aurait pas permis de déceler un front de modulation.

Pour la transmission des données depuis la carte vers le terminal, celle-ci s'effectue par une détection de l'absorption d'énergie consommée par l'objet portatif. En d'autres termes, la transmission s'effectue dans ce sens par une modulation par absorption.

On se place toujours dans le cas où la tension VNR est supérieure à la tension de seuil choisie, le transistor principal TZ1 conduisant.

Classiquement, lors de la transmission d'un bit de valeur logique 1 (signal ST à l'état haut), le transistor TZ5 conduit et crée un appel de courant supplémentaire. Cependant, sans la présence du transistor TZ2 et du commutateur formé par les transistors TZ3 et TZ4, la diode Zener du limiteur de tension absorberait le surplus d'énergie ce qui ne permettrait pas de déceler l'information transmise.

Le transistor TZ2 monté en miroir de courant par l'intermédiaire du commutateur TZ3 et TZ4 permet de remédier à cet inconvénient tout en autorisant l'écrêtement de la tension d'alimentation.

Plus précisément, quand le signal ST est à l'état bas, correspondant à l'émission d'un bit de valeur logique zéro, la tension au niveau de la borne de commande BC est à l'état haut (en raison de la présence de l'inverseur IV). De ce fait, le transistor TZ4 conduit tandis que le transistor TZ3 est bloqué. La tension de grille du transistor TZ2 étant nulle, ce dernier est bloqué et le transistor TZ2 n'absorbe aucun courant supplémentaire.

Par contre, lorsque le signal ST est à l'état haut, correspondant à la transmission d'un bit de logique de valeur 1, le transistor TZ4 est bloqué tandis que le transistor TZ3 conduit. De ce fait, le transistor TZ2 conduit avec un courant égal au courant de conduction du transistor TZ1. Il en résulte donc un courant supplémentaire d'absorption par rapport au cas précédent, ce qui permet de déceler sans difficulté l'absorption supplémentaire occasionnée par la transmission du bit logique de valeur 1.

## Revendications

1. Procédé d'échange d'informations à distance entre un objet électronique portatif, en particulier une carte à mémoire, et un terminal par une modulation du champ magnétique généré par le terminal, selon lequel lors d'une transmission d'informations depuis le terminal vers l'objet OB, on effectue une modulation d'amplitude (MD) du champ magnétique, et caractérisé par le fait que, lorsque la tension d'alimentation (VNR) ainsi modulée et récupérée au niveau d'une borne d'entrée (BE) de l'objet portatif, dépasse une valeur limite choisie lors d'un pic de modulation (PC), on écrête cette tension à ladite valeur limite choisie tout en faisant circuler un premier courant (IO) dans un transistor principal (TZ1) connecté entre ladite borne et la masse, puis, lors d'un creux de modulation (CRX), on fait circuler dans le transistor principal un second courant (I1) ayant une valeur sensiblement égale à celle du premier courant (IO) circulant lors du pic de modulation.

2. Procédé selon la revendication 1, caractérisé par le fait qu'on maintient le premier courant dans le transistor principal (TZ1) sensiblement constant entre un pic et un creux de modulation en maintenant sensiblement constante sa tension de grille.

3. Procédé selon la revendication 1 ou 2, caractérisé par le fait que, lors d'une transmission d'informations depuis l'objet vers le terminal, on commande, en fonction de la valeur logique des bits d'informations à transmettre, la conduction ou le blocage d'un transistor auxiliaire (TZ2) monté en miroir de courant avec le transistor principal (TZ1).

4. Objet électronique portatif, en particulier une carte à mémoire, capable d'échanger à distance des informations avec un terminal par une modulation du champ magnétique généré par le terminal, caractérisé par le fait qu'il comprend un limiteur de tension (LMT) comportant une borne d'entrée (BE) pour recevoir, lors d'une transmission d'informations entre le terminal et l'objet, une tension (VNR) modulée en amplitude dont le niveau moyen (NM) est susceptible de varier temporellement, un transistor principal (TZ1) connecté entre la borne d'entrée et la masse, un ensemble de diodes (D1,..., DN) connectées en série d'une part entre la borne d'entrée (BE) et la masse et d'autre part entre la borne d'entrée (BE) et la grille du transistor principal (TZ1), les tensions de seuil des diodes et du transistor principal définissant une valeur limite de la tension d'entrée, une capacité (C) connectée entre la grille du transistor principal et la masse, et un réseau résistif (RD, TR) connecté entre la capacité et la masse et formant avec la capacité un réseau résistif/capacitif dont la constante de temps est choisie comprise entre la durée de variation temporelle du niveau moyen de la tension et la période de la modulation d'amplitude.

5. Objet selon la revendication 4, caractérisé par le fait que l'ensemble de diodes comporte une première diode terminale (DM) dont la cathode est directement connectée à la grille du transistor principal et une deuxième diode terminale (DN) dont l'anode est reliée à l'anode de la première diode terminale (DN) et dont la cathode est reliée à la masse par l'intermédiaire d'une résistance de polarisation (RD), et par le fait que le réseau résistif comprend, outre la résistance de polarisation (RD), un deuxième transistor à effet de champ (TR) connecté en série entre cette résistance de polarisation et la grille du transistor principal, la grille de ce deuxième transistor à effet de champ étant reliée à la masse.

6. Objet selon la revendication 4 ou 5, caractérisé par le fait que le limiteur de tension comporte une entrée de commande (BC) apte à recevoir un signal de commande dont la valeur dépend de la valeur des bits des informations transmises de l'objet vers le terminal, et un transistor auxiliaire (TZ2) monté en miroir de courant avec le transistor principal par l'intermédiaire d'un commutateur commandé par le signal de commande.

7. Objet selon la revendication 6, caractérisé par le fait que le transistor auxiliaire (TZ2) est connecté entre la borne d'entrée et la masse, et par le fait que le commutateur comporte deux transistors complémentaires (TZ3, TZ4) dont les grilles sont reliées à l'entrée de commande, l'un de ces deux transistors étant connecté entre la grille du transistor principal et la grille du transistor auxiliaire tandis que l'autre transistor est connecté entre la grille du transistor auxiliaire et la masse.

## Patentansprüche

1. Verfahren zum Austauschen von Informationen über eine Distanz hinweg zwischen einem tragbaren elektronischen Objekt, insbesondere einer Speicherkarte, und einem Endgerät mittels einer durch das Endgerät erzeugten Magnetfeldmodulation, gemäß dem bei einem Senden von Informationen von dem Endgerät zu dem Objekt (OB) eine Amplitudenmodulation (MD) des Magnetfelds durchgeführt wird, und **dadurch gekennzeichnet, daß,** wenn die so modulierte und auf der Ebene eines Eingangsanschlusses (BE) des tragbaren Objekts wiedergewonnene Versorgungsspannung (VNR) einen ausgewählten Grenzwert überschreitet, diese Spannung bei einem Modulationsspitzenwert (PC) auf den ausgewählten Grenzwert spitzenwertbegrenzt wird, während ein erster Strom (IO) in einem zwischen den Anschluß und Masse geschalteten Haupttransistor (TZ1) zum Fließen gebracht wird, dann, bei einem Modulationstal (CRX) ein zweiter Strom (I1) mit einem dem des bei dem Modulationsspitzenwert fließenden ersten Stroms (IO) im wesentlichen gleichen Wert in dem Haupttransistor zum Fließen gebracht wird.

2. Verfahren nach Anspruch 1, **dadurch gekennzeichnet, daß** der erste Strom in dem Haupttransistor (TZ1) zwischen einem Modulationsspitzenwert und einem Modulationstal im wesentlichen konstant gehalten wird, indem dessen Steuerelektrodenspannung im wesentlichen konstant gehalten wird.

3. Verfahren nach Anspruch 1 oder 2, **dadurch gekennzeichnet, daß** bei einem Senden von Informationen von dem Objekt zu dem Endgerät hin das Leiten oder Sperren eines mit dem Haupttransistor (TZ1) als Stromspiegel verschalteten Hilfstransistors (TZ2) abhängig von dem Logikwert der zu sendenden Informationsbits gesteuert wird.

4. Tragbares elektronisches Objekt, insbesondere eine Speicherkarte, die dazu geeignet ist, über eine Distanz hinweg Informationen mit einem Endgerät mittels einer durch das Endgerät erzeugten Magnetfeldmodulation auszutauschen, **gekennzeichnet durch** einen Spannungsbegrenzer (LMT) mit einem Eingangsanschluß (BE), um bei einem Senden von Informationen zwischen dem Endgerät und dem Objekt eine amplitudenmodulierte Spannung (VNR) zu empfangen, deren mittlerer Pegel (NM) temporär variieren kann, einem zwischen den Eingangsanschluß und Masse geschalteten Haupttransistor (TZ1), einer Anordnung von Dioden (D1, ..., DN), die in Reihe geschaltet einerseits zwischen den Eingangsanschluß (BE) und Masse und andererseits zwischen den Eingangsanschluß (BE) und die Steuerelektrode des Haupttransistors (TZ1) geschaltet sind, wobei die Schwellenspannungen der Dioden und des Haupttransistors einen Grenzwert der Eingangsspannung definieren, einem zwischen die Steuerelektrode des Haupttransistors und Masse geschalteten Kondensator (C), und einem zwischen den Kondensator und Masse geschalteten Widerstandsnetz (RD, TR), welches mit dem Kondensator ein resistiv-kapazitives Netz bildet, dessen Zeitkonstante als zwischen der Dauer der temporären Änderung des mittleren Pegels der Spannung und der Periode der Amplitudenmodulation liegend gewählt ist.

5. Objekt nach Anspruch 4, dadurch gekennzeichnet, daß die Anordnung von Dioden eine erste Abschlußdiode (DM), deren Kathode direkt mit der Steuerelektrode des Haupttransistors verbunden ist, und eine zweite Abschlußdiode (DN), deren Anode mit der Anode der ersten Abschlußdiode (DN) verbunden ist und deren Kathode über einen Polarisationswiderstand (RD) mit Masse verbunden ist, aufweist, und dadurch, daß das Widerstandsnetz außer dem Polarisationswiderstand (RD) einen zweiten, auf dem Feldeffekt beruhenden Transistor (TR) aufweist, der in Reihe zwischen diesen Polarisationswiderstand und die Steuerelektrode des Haupttransistors geschaltet ist, wobei die Steuerelektrode des zweiten, auf dem Feldeffekt beruhenden Transistors mit Masse verbunden ist.

6. Objekt nach Anspruch 4 oder 5, dadurch gekennzeichnet, daß der Spannungsbegrenzer einen Steuereingang (BC), der geeignet ist, ein Steuersignal zu empfangen, dessen Wert von dem Wert der von dem Objekt zum Endgerät gesendeten Informationsbit abhängt, und einen mit dem Haupttransistor über einen durch das Steuersignal gesteuerten Umschalter als Stromspiegel verschalteten Hilfstransistor (TZ2) aufweist.

7. Objekt nach Anspruch 6, dadurch gekennzeichnet, daß der Hilfstransistor (TZ2) zwischen den Eingangsanschluß und Masse geschaltet ist und daß der Umschalter zwei komplementäre Transistoren (TZ3, TZ4) aufweist, deren Steuerelektroden mit dem Steuereingang verbunden sind, wobei einer der beiden Transistoren zwischen die Steuerelektrode des Haupttransistors und die Steuerelektrode des Hilfstransistors geschaltet ist, während der andere Transistor zwischen die Steuerelektrode des Hilfstransistors und Masse geschaltet ist.

## Claims

1. Process for the remote exchange of information between a portable electronic object, in particular a memory card, and a terminal by modulation of the magnetic field generated by the terminal, according to which, when transmitting information from the terminal to the object OB, an amplitude modulation (MD) of the magnetic field is performed, and characterized in that, when the energizing voltage (VNR) thus modulated and recovered at an input port (BE) of the portable object exceeds a chosen limit value during a modulation peak (PC), this voltage is clipped to the said chosen limit value whilst also causing a first current (IO) to flow through a main transistor (TZ1) connected between the said port and earth, then, during a modulation trough (CRX), a second current (I1) having a value substantially equal to that of the first current (IO) flowing during the modulation peak is caused to flow through the main transistor.

2. Process according to Claim 1, characterized in that the first current in the main transistor (TZ1) is kept substantially constant between a modulation peak and trough by keeping its gate voltage substantially constant.

3. Process according to Claim 1 or 2, characterized in that, when transmitting information from the object to the terminal, an auxiliary transistor (TZ2) mounted in current-mirror mode with the main transistor (TZ1) is switched on or off depending on the logic value of the information bits to be transmitted.

4. Portable electronic object, in particular a memory card, capable of exchanging information remotely with a terminal by modulation of the magnetic field generated by the terminal, characterized in that it comprises a voltage limiter (LMT) consisting of an input port (BE) for receiving, when transmitting information between the terminal and the object, an amplitude-modulated voltage (VNR) whose mean level (NM) is able to vary temporally, a main transistor (TZ1) connected between the input port and earth, a set of diodes (D1,...DN) connected in series on the one hand between the input port (BE) and earth and on the other hand between the input port (BE) and the gate of the main transistor (TZ1), the threshold voltages of the diodes and of the main transistor defining a limit value of the input voltage, a capacitor (c) connected between the gate of the main transistor and earth, and a resistive network (RD, TR) connected between the capacitor and earth and forming with the capacitor a resistive/capacitive network whose time constant is chosen to lie between the duration of temporal variation of the mean level of the voltage and the period of the amplitude modulation.

5. Object according to Claim 4, characterized in that the set of diodes consists of a first terminal diode (DM) whose cathode is connected directly to the gate of the main transistor and a second terminal diode (DN) whose anode is linked to the anode of the first terminal diode (DN) and whose cathode is linked to earth by way of a biasing resistor (RD), and in that the resistive network comprises, in addition to the biasing resistor (RD), a second field-effect transistor (TR) connected in series between this biasing resistor and the gate of the main transistor, the gate of this second field-effect transistor being linked to earth.

6. Object according to Claim 4 or 5, characterized in that the voltage limiter consists of a control input (BC) able to receive a control signal whose value depends on the value of the bits of the information transmitted from the object to the terminal, and an auxiliary transistor (TZ2) mounted in current-mirror mode with the main transistor by way of a switch controlled by the control signal.

7. Object according to Claim 6, characterized in that the auxiliary transistor (TZ2) is connected between the input port -and earth, and in that the switch consists of two complementary transistors (TZ3, TZ4) whose gates are linked to the control input, one of these two transistors being connected between the gate of the main transistor and the gate of the auxiliary transistor whilst the other transistor is connected between the gate of the auxiliary transistor and earth.
